Europäisches Patentamt

**European Patent Office**

Office européen des brevets

(19)

(11) Numéro de publication: **0 226 480**
**B1**

(12) # FASCICULE DE BREVET EUROPEEN

(45) Date de publication du fascicule du brevet:
**01.08.90**

(51) Int. Cl.⁵: **H01L 23/48,** H01L 23/50,
H01L 23/04

(21) Numéro de dépôt: **86402241.3**

(22) Date de dépôt: **09.10.86**

(54) **Procédé de fabrication d'un microboîtier, microboîtier à contacts effleurants, et application aux cartes contenant des composants.**

(30) Priorité: **11.10.85 FR 8515114**

(43) Date de publication de la demande:
**24.06.87 Bulletin 87/26**

(45) Mention de la délivrance du brevet:
**01.08.90 Bulletin 90/31**

(84) Etats contractants désignés:
**CH DE FR GB LI NL**

(56) Documents cités:
**DE-A- 3 130 213**
**FR-A- 2 483 128**
**GB-A- 2 082 397**
**GB-A- 2 096 541**
**GB-A- 2 149 209**
**US-A- 4 276 558**

(73) Titulaire: **THOMSON COMPOSANTS MILITAIRES ET SPATIAUX, 173, Bd Haussmann, F-75008 Paris(FR)**

(72) Inventeur: **Gloton, Jean-Pierre, THOMSON-CSF SCPI 19, avenue de Messine, F-75008 Paris(FR)**
Inventeur: **Peres, Philippe, THOMSON-CSF SCPI 19, avenue de Messine, F-75008 Paris(FR)**

(74) Mandataire: **Guérin, Michel et al, THOMSON-CSF SCPI, F-92045 PARIS LA DEFENSE CEDEX 67(FR)**

## Description

La présente invention concerne un procédé de fabrication d'un microboitier. L'invention concerne aussi un microboitier à contacts effleurants. Elle concerne enfin une application d'un tel microboitier à une carte contenant des composants de type CCC.

Des microboitiers sont décrits dans les documents US-A 4 276 558 et GB-A 2 149 209.

Une carte de type CCC, utilisée par exemple en paiement électronique comporte un support au format carte de crédit et implanté à la surface du support, un microboitier appelé aussi micromodule qui comporte à la fois la connectique, l'encapsulation et le circuit électronique de la carte.

D'après l'art antérieur, on sait fabriquer des micromodules comportant sur un support des parties conductrices et un circuit semiconducteur par exemple sur substrat silicium. A la fin de l'opération de fabrication on dépose une goutte de résine thermodurcissable par dessus le circuit pour le protéger avec ses connexions et améliorer la rigidité mécanique du micromodule.

Mais la viscosité des résines rend difficile la garantie de précisions suffisantes des dimensions de la goutte déposée. Or, le montage du micromodule dans la carte CCC, opération dite d'encartage, demande que certaines dimensions extérieures du micromodule soient respectées. Il faut en effet que le micromodule soit bien placé en profondeur dans la carte pour éviter de dépasser ou de former un creux. Dans la première situation, le micromodule peut être arraché à l'introduction de la carte dans le lecteur de cartes CCC. Dans la seconde situation, le creux est susceptible de créer une zone de colmatage pour les salissures qui peuvent alors masquer les contacts. Il faut aussi que le micromodule soit convenablement disposé dans le plan de la carte. En effet, les contacts du micromodule apparaissent à la surface de la carte et sont disposés pour être lus par des contacts d'un lecteur. On conçoit que la forme et les dimensions de la goutte de résine soient déterminantes pour la bonne qualité de la carte. Or, dans les procédé anciens, il faut rectifier la goutte par meulage et sa forme n'est pas réellement optimisée.

Pour remédier à ces inconvénients, l'invention propose un procédé de fabrication d'un microboitier. Selon ce procédé on constitue sur un support isolant une succession de plages conductrices munies de zones de contact accessible de l'extérieur du microboitier. L'une de ces plages conductrices reçoit un circuit semiconducteur relié électriquement par des fils aux autres plages conductrices. Puis on dépose sur la face du support portant le circuit semiconducteur un boitier creux. Enfin on remplit le boitier creux d'une résine destinée à protéger le circuit semiconducteur et ces connexions.

L'invention concerne aussi une nouvelle structure qui concerne un microboitier disposé sur un support et muni de contacts électriques reliés à un circuit semiconducteur porté par le support. Le microboitier selon l'invention comporte une capsule destinée à enrober une goutte de résine déposée par dessus le circuit de manière à en garantir la forme et les dimensions.

D'autres avantages et caractéristiques de la présente invention seront mieux compris à l'aide de la description et des dessins qui sont :

- la figure 1 : une vue de dessous d'un microboitier selon l'invention,
- la figure 2 : la vue de face correspondante, en coupe,
- la figure 3 : la vue de dessous correspondante.

Sur les dessins, le microboitier a été figuré sans que le circuit et ses fils de liaison soient installés. Dans le procédé selon l'invention, on commence par fabriquer un module constitué d'un support et de contacts.

Dans un mode de réalisation préféré, le module est réalisé à partir d'un film plastique métallisé. Par un procédé de gravure comme un procédé photochimique on dessine sur le film des zones de contacts en enlevant le métal largement entre ces zones. Des régions de contacts 20-25 sont ménagées pour permettre d'accéder aux bornes électriques du microboitier. Une zone centrale sert de contact de substrat au circuit semi-conducteur non représenté au dessin. Ce circuit est de forme sensiblement parallélépipédique. Des fils conducteurs sont soudés sur le circuit pour le relier électriquement sur une face ou l'autre des plages conductrices 20-25, bornes d'accès électrique du microboitier.

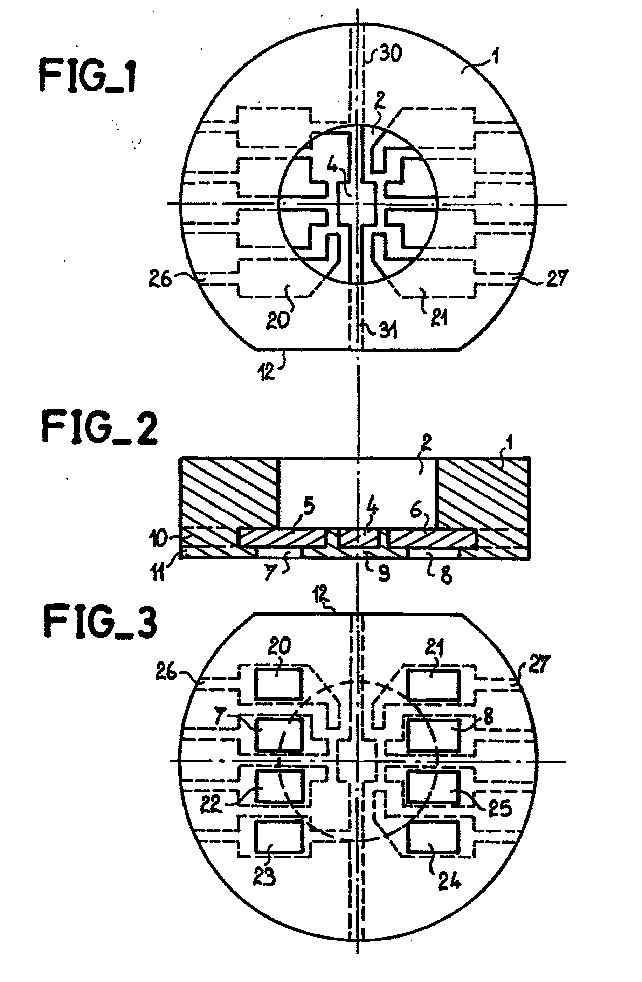

Dans un exemple de réalisation les fils électriques reliant sur la figure 2 par exemple la zone 5 au circuit semiconducteur disposé sur la zone 4 sont soudés sur la partie supérieure du support. A la figure 2 on remarque que le microboitier comporte une partie annulaire 1 disposée au-dessus du support 11. Dans le procédé selon l'invention cette partie annulaire est réalisée en un matériau plastique qui peut se souder à chaud sur le support 11. Le boitier annulaire 1 réalise une capsule qui permet en particulier d'emprisonner une partie des connexions constituées par les plages conductrices comme les plages 22-25. Un premier effet de ce boitier est donc d'améliorer la tenue mécanique de ces plages conductrices métalliques réalisées sur des bandes métalliques de très faible épaisseur.

Le boitier annulaire 1 comporte aussi un perçage 2 central à travers lequel le circuit semi-conducteur est déposé sur la zone centrale 4. A la fin du procédé de fabrication d'un micromodule, on charge l'intérieur du trou 2 avec une résine thermodurcissable. Un autre effet de l'invention est de permettre ainsi de calibrer exactement la forme de la goutte de résine que l'art antérieur apprend à déposer sur un semiconducteur déposé sur une plage conductrice comme la plage 4.

On remarquera que, dans l'exemple de réalisation décrit, les parties métalliques sont entièrement incluses à l'intérieur du support et du boitier 1. Seuls, des perçages comme les perçages 20-24, permettent un accès électrique une fois le micromodule fabriqué. Dans une variante d'exécution une métallisation de ces perçages est réalisée en plus afin de permettre une meilleure lecture. Cette disposition est favorable pour éviter les problèmes de décollement des plages conductrices à la lecture.

Selon une autre caractéristique de l'invention, les parties conductrices sont réalisées par des coupes ou photogravures dans une bande métallique. Les découpes sont telles que un dessin particulier de connexion correspondant au circuit total désiré est dessiné en plus des pattes supplémentaires comme les pattes 26 et 27 sur les plages conductrices 20 et 21 de la figure 1 sont prévues de manière à renforcer l'ancrage de chaque patte conductrice dans le micromodule. De même la zone centrale est prolongée par des pattes 30-31.

**Revendications**

1. Procédé de fabrication d'un microboitier qui consiste à constituer sur un support (11) isolant une succession de plages conductrices (5, 6) munies de zones de contacts (23, 24) accessibles de l'extérieur du microboitier (1) par des alésages (7, 8), à déposer sur une plage conductrice centrale (4) un circuit semiconducteur puis à le relier électriquement aux autres plages conductrices, à déposer sur la face du support portant le circuit semiconducteur un boitier annulaire (1), à fixer celui-ci sur le support (11) puis à remplir le boitier annulaire d'une résine destinée à protéger le circuit semiconducteur et ses connexions.

2. Microboitier qui comporte un support isolant sur une face duquel est déposée une succession de plages conductrices, chaque plage conductrice comportant une zone de contact (20) accessible par un alésage (7), une plage conductrice centrale (4) portant un circuit semiconducteur relié par des fils aux autres plages conductrices, l'ensemble constitué par le support (11) et les plages conductrices (20-24) étant recouvert d'un boitier annulaire (1) dont l'alésage (2) est rempli d'une résine destinée à protéger le circuit semiconducteur et ses connexions.

3. Microboitier selon la revendication 2, caractérisé en ce que chaque plage conductrice est prolongée par une patte (26) d'ancrage dans le microboitier.

4. Microboitier selon la revendication 2, caractérisé en ce que les alésages (7, 8) de lecture des plages conductrices (5, 6) sont munies d'un film conducteur.

5. Micromodule selon la revendication 2, caractérisé en ce que le boitier et le support sont de forme générale cylindrique de section sensiblement circulaire coupée par une partie de guidage plane (12).

**Claims**

1. A method of manufacturing a microhousing consisting in the formation, on an insulating support (11), of a succession of conducting areas (5, 6) provided with contact zones (23, 24) accessible from outside the microhousing (1) via bores (7, 8), the deposition of a semiconductor circuit on acentral conducting area (4) followed by connecting said circuit electrically to the other conducting areas, the deposition of an annular housing (1) on the face of the support carrying the semiconductor circuit, the fixation of said housing on the support (11) and then the filling of the annular housing with a resin intended to protect the semiconductor circuit and its connections.

2. A microhousing, comprising an insulating support, onto one face of which there is deposited a succession of conducting areas, each conducting area comprising a contact zone (20) accessible via a bore (7), a central conducting area (4) carrying a semiconductor circuit connected by wires to the other areas, the support (11) and the conducting areas (20 to 24) being covered by an annular housing (1), whose bore (2) is filled with a resin intended to protect the semiconductor circuit and its connections.

3. A microhousing according to claim 2, characterized in that each conducting area is extended by an anchoring pad (26) within the microhousing.

4. A microhousing according to claim 2, characterized in that the read-out bores (7, 8) of the conducting areas (5, 6) are provided with a conducting film.

5. A micromodule according to claim 2, characterized in that the housing and the support have an overall cylindrical shape of a substantially circular cross-section, which section is cut off by a plane guiding portion (12).

**Patentansprüche**

1. Verfahren zur Herstellung eines Mikrogehäuses, demgemäß auf einem Isolierträger (11) eine Folge von leitenden Bereichen (5, 6) mit von außerhalb des Mikrogehäuses (1) durch Bohrungen (7, 8) zugänglichen Kontaktzonen (2) hergestellt wird, auf einen zentralen leitenden Bereich (4), eine Halbleiterschaltung aufgebracht wird, die dann elektrisch mit den anderen leitenden Bereichen verbunden wird, auf der die Halbleiterschaltung tragenden Seite des Trägers ein ringförmiges Gehäuse (1) aufgebracht wird, das auf dem Träger (11) befestigt wird, und dann das ringförmige Gehäuse mit einem Harz zum Schutze der Halbleiterschaltung und ihrer Anschlüsse gefüllt wird.

2. Mikrogehäuse, mit einem Isolierträger, bei dem auf einer Fläche eine Folge von leitenden Bereichen aufgebracht ist, wobei jeder leitende Bereich eine durch eine Bohrung (7) zugängliche Kontaktzone (20) aufweist, wobei ein zentraler leitender Bereich (4) eine durch Drähte mit den anderen leitenden Bereichen verbundene Halbleiterschaltung trägt und wobei der Träger (11) und die leitenden Bereiche (20 bis 24) mit einem ringförmigen Gehäuse (1) bedeckt sind, dessen Bohrung (2) mit einem Harz zum Schutze der Halbleiterschaltung und ihrer Anschlüsse gefüllt ist.

3. Mikrogehäuse nach Anspruch 2, dadurch gekennzeichnet, daß jeder leitende Bereich durch eine Verankerungsfahne (26) im Mikrogehäuse verlängert ist.

4. Mikrogehäuse nach Anspruch 2, dadurch gekennzeichnet, daß die Bohrungen (7, 8) zum Abta-

sten der Halbleiterbereiche (5, 6) mit einer leitenden Schicht versehen sind.

5. Mikromodul nach Anspruch 2, dadurch gekennzeichnet, daß das Gehäuse und der Träger eine zylindrische Gesamtform mit im wesentlichen kreisförmigem Querschnitt besitzen, welche einen flachen Führungsabschnitt (12) aufweist.

EP 0 226 480 B1

**FIG_1**

**FIG_2**

**FIG_3**